# EUROPÄISCHE PATENTSCHRIFT

(11) **EP 1 311 933 B1**
(45) Veröffentlichungstag und Bekanntmachung des Hinweises auf die Patenterteilung: **24.12.2008**
(21) Anmeldenummer: 01969248.2
(22) Anmeldetag: 21.08.2001
(51) Int. Cl.: G06F 1/04

(54) **TAKTGENERATOR, INSBESONDERE FÜR USB-GERÄTE**
CLOCK GENERATOR, PARTICULARLY FOR USB DEVICES
GENERATEUR D'HORLOGE, NOTAMMENT POUR DISPOSITIFS USB

(30) Priorität: 25.08.2000 DE 10041772
(43) Veröffentlichungstag der Anmeldung: 21.05.2003
(73) Patentinhaber: Infineon Technologies AG, 81669 München (DE)
(72) Erfinder: BRUHNKE, Michael, 80809 Muenchen (DE); PREIS, Viktor, 82024 Taufkirchen (DE); WEDER, Uwe, 84072 Au/Hallertau (DE)
(74) Vertreter: Epping - Hermann - Fischer
(86) Internationale Anmeldenummer: PCT/DE2001/003187
(87) Internationale Veröffentlichungsnummer: WO 2002/017047

(56) Entgegenhaltungen:
- US-A- 5 280 195

## Beschreibung

Die Erfindung betrifft eine Taktgeneratoreinheit, die insbesondere in Verbindung mit USB-Geräten Verwendung findet. Gemäß der USB-Spezifikation muß für die Datenübertragungsraten eine bestimmte Genauigkeit eingehalten werden. Im Full-Speed-Modus ist eine Genauigkeit von +/- 0,25 % gefordert. Diese Genauigkeit läßt sich nur über die Taktgenauigkeit erreichen, der verwendete Takt muß also auch diese hoheGenauigkeit aufweisen. Der USB-Bus enthält allerdings keine explizite Taktleitung. Daher muß jedes Gerät eine eigene Generierung des Taktes vorsehen. Wird die Genauigkeit für das Taktsignal nicht erreicht, dann ist das Gerät nicht USB-kompatibel.

Taktsignale werden üblicherweise mit einer Schaltung auf einem Chip erzeugt, wobei eine Genauigkeit von +/- 3 % erreicht werden kann. Zu Erhöhung der Genauigkeit ist es bekannt, einen zusätzlichen Quarz zu verwenden. Solche Quarzoszillatorschaltungen sind beispielsweise aus "Tietze, Schenk: Halbleiter-Schaltungstechnik, Springer Verlag 1999, 11. Auflage, Seite 910 ff.", bekannt. Der Quarzbaustein ist dabei als externes Bauteil realisiert. Für viele Anwendungen ist es allerdings erforderlich oder wünschenswert, daß sich sämtliche Bausteine auf einem Chip befinden. Bei der Verwendung eines externen Quarzes sind ein oder zwei zusätzliche Pins an dem Chip erforderlich, was in der Regel unerwünscht ist und zusätzliche Kosten verursacht. Ein weiteres Problem stellt die Größe eines Quarzes dar, denn beispielsweise bei Chipkarten soll beziehungsweise kann eine Dicke von 800 µm nicht überschritten werden. Mit einem Quarz ist die Einhaltung dieser Vorgaben nicht möglich.

Die US-A-5280195 offenbart eine Taktgeneratoreinheit mit einem Taktgenerator und einem Pulszähler. Der Pulszähler dient zur Generierung eines internen Taktsignals, dessen Frequenz geringer ist als die eines "MASTER CLOCK" genannten Referenzsignals.

Aufgabe der Erfindung ist es, eine Taktgeneratoreinheit anzugeben, die Taktsignale mit einer besonders hohen Genauigkeit erzeugt, aber trotzdem ohne einen Quarzbaustein auskommt.

Diese Aufgabe wird durch eine Taktgeneratoreinheit gelöst mit den Merkmalen des Anspruchs 1.

Die Funktionsweise der erfindungsgemäßen Taktgeneratoreinheit beruht darauf, daß gemäß den USB-Spezifikationen in regelmäßigen Abständen, im Full-Speed-Modus beispielsweise jede Millisekunde, ein Synchronisationspuls übertragen wird, wobei die Frequenz dieses Synchronisationssignales eine viel höhere Genauigkeit besitzt als die geforderte Datenübertragungsrate. Ausgehend von dem festen Abstand der Pulse des Synchronisationssignals und der gewünschten Sollfrequenz ist festgelegt, wie viele Taktimpulse der Taktgenerator zwischen zwei Impulsen des Synchronisationssignals erzeugen muß. Durch Vergleich der Sollanzahl von Pulsen mit der Istanzahl von Pulsen zwischen zwei vorhergehenden Synchronisationspulsen ist bekannt, wie weit die Isttaktfrequenz von der Solltaktfrequenz abweicht. Durch das Ausfiltern von überzähligen Pulsen aus dem intern erzeugten Taktsignal kann die Isttaktfrequenz auf die erforderliche Solltaktfrequenz reduziert werden.

In einer vorteilhaften Ausgestaltung wird nicht nur die Anzahl von Pulsen zwischen zwei vorhergehenden Synchronisationssignalen ausgewertet, sondern ein Mittelwert zwischen mehreren Perioden gebildet. Dadurch läßt sich die Schwankungsbreite der Frequenz weiter reduzieren.

Vorteilhaft ist, daß die erfindungsgemäße Taktgeneratoreinheit unabhängig ist von Parametern wie Technologie, Temperatur oder Stromaufnahme. Daher können teure Maßnahmen zur Einhaltung von Herstellungstoleranzen eingespart werden.

Gemäß den USB-Spezifikationen ist die Genauigkeit der Synchronisationssignale um einen Faktor größer als fünf genauer als die Genauigkeit der benötigten stabilisierten Taktfrequenz. Dadurch bleibt ein ausreichend großer Änderungsbereich für die Abstimmung der Komponenten übrig.

Für die Genauigkeit ist es weiterhin von Vorteil, wenn es sich bei dem stabilisierten Taktsignal um ein internes stabilisiertes Taktsignal handelt, dessen Frequenz in einem gradzahligenVerhältnis höher ist als die Solltaktfrequenz eines Arbeitstaktsignales. Dabei ist ein Frequenzteiler vorgesehen, der aus dem internen stabilisierten Taktsignal das Arbeitstaktsignal mit der vorgeschriebene Solltaktfrequenz erzeugt.

Ein weiterer Vorteil entsteht, wenn der Wert des Pulsspeichers und/oder das Ausgangssignal eines Synchronisationsdecoders und/oder das Ausgangssignal eines Signaldecoders auf den internen Taktgenerator zurückgekoppelt werden und dadurch die Frequenz des internen Taktgenerators nachjustierbar ist.

Weitere Einzelheiten und Ausgestaltungen der Erfindung sind in den Unteransprüchen angegeben.

Die Erfindung wird nachfolgend anhand eines Ausführungsbeispieles näher erläutert. Es zeigt:
- Figur 1: die Verbindung zweier Geräte gemäß dem USB-Standard,
- Figur 2: ein erstes einfaches Ausführungsbeispiel einer Taktgeneratoreinheit als Blockschaltbild und
- Figur 3: ein zweites erweitertes Ausführungsbeispiel der Taktgeneratoreinheit von Figur 2 ebenfalls als Blockschaltbild.

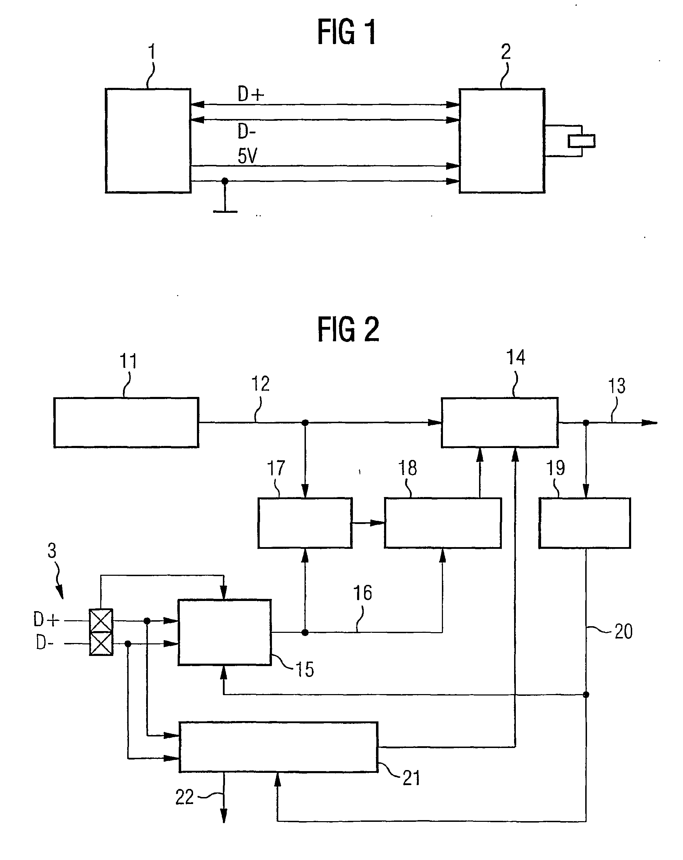

Eine USB-Verbindung wird gemäß Figur 1 zwischen zwei Geräten realisiert, wobei eines als USB-Host 1 und das andere als USB-Gerät 2 bezeichnet wird. Die Rolle des USB-Host 1 übernimmt beispielsweise ein PC oder ein HUB. Als USB-Gerät 2 kann ebenfalls ein HUB oder beispielsweise eine Tastatur, eine Maus, ein Scanner oder auch eine Chipkarte eingesetzt werden. Neben einer Verbindung mit 5 Volt und einer Masseverbindung sind zwei Datenleitungen D+ und D- vorgesehen. Über die beiden Datenleitungen D+ und D- läuft der Datenverkehr zwischen dem USB-Host 1 und dem USB-Gerät 2. Je nachdem, wie groß der Strombedarf des USB-Gerätes 2 ist, erfolgt die Spannungsversorgung über die Busverbindung oder über eine eigene Spannungsversorgung.

Eine Taktleitung ist gemäß den USB-Spezifikationen nicht vorgesehen. Daher muß jedes USB-Gerät einen eigenen Taktgenerator besitzen, der, wie in der Beschreibungseinleitung ausgeführt, hohen Genauigkeitsansprüchen gerecht werden muß. Zur Synchronisation des Datenverkehrs zwischen dem USB-Host 1 und dem USB-Gerät 2 sendet der USB-Host 1 im Full-Speed-Modus im Abstand von 1 ms ein Synchronisationssignal. Dies weist im Full-Speed-Modus eine Genauigkeit von 0,05 % auf.

Die Figur 2 beschreibt nun eine Taktgeneratoreinheit eines USB-Gerätes 2, das die eingehenden hochgenauen Synchronisationssignale dazu ausnutzt, ein intern erzeugtes Taktsignal zu manipulieren, um die geforderte Genauigkeit der Datenübertragungsrate zu erreichen.

Ein interner Taktgenerator 11 erzeugt ein unstabilisiertes Taktsignal 12, dessen Frequenz höher ist als eine angestrebte stabilisierte Frequenz. Um von dem unstabilisierten Taktsignal 12 zu einem stabilisierten Taktsignal 13 zu gelangen, werden in einem Pulsfilter 14 einzelne Impulse unterdrückt. Um zu der Information zu gelangen, wie viele Pulse unterdrückt werden müssen, wird die Anzahl der zwischen zwei Pulsen des Synchronisationssignales 16 erzeugten Pulse des unstabilisierten Taktsignals 12 gezählt und mit einer Sollpulszahl verglichen.

Ein Synchronisations-Decodierer 15 decodiert aus einem Eingangssignal 3 auf den Datenleitungen D+ und D- das Synchronisationssignal 16. Durch die Pulse des Synchronisationssignals 16 wird ein Pulszähler 17 zurückgesetzt. Nachfolgend wird er durch die Pulse des unstabilisierten Taktsignals 12 hochgezählt. Gleichzeitig mit dem Zurücksetzen des Pulszählers 17 wird der aktuelle Zählerstand in einen Pulszahlspeicher 18 geschrieben. Der in dem Pulszahlspeicher stehende Wert beschreibt also die Anzahl der Taktpulse 12, die zwischen zwei vorhergehenden Synchronisationspulsen 16 erzeugt worden sind. Der Pulszahlspeicher 18 ist mit dem Pulsfilter 14 verbunden, so daß der Pulsfilter 14 auswerten kann, wie groß die Differenz zwischen der Sollpulszahl und der in der letzten Periode erzeugten Pulszahl ist. Diese Anzahl Pulse wird nun aus dem internen Taktsignal 12 ausgefiltert. Wenn die Taktfrequenz des internen Taktgenerators 11 während zweier Synchronisationssignalperioden gleich bleibt, entspricht die Frequenz am Ausgang des Pulsfilters 14 also in der zweiten Periode genau der Sollfrequenz.

Das Ausgangssignal des Pulsfilters 14, also das stabilisierte Taktsignal 13, ist in einer günstigen Form wesentlich höher als das benötigte Taktsignal 20 und steht in einem gradzahligen Verhältnis dazu. Durch einen Frequenzteiler 19 wird dann das letztlich benötigte Arbeitstaktsignal 20, bei USB Full-Speed beträgt seine Frequenz 12 MHz, gewonnen. Die Sollfrequenz für das stabilisierte Taktsignal wäre dann 48 MHz, wenn der Frequenzzähler 19 im Verhältnis von 4:1 realisiert wird. Das Arbeitstaktsignal 20 mit 12 MHz wird anschließend dem Synchronisations-Decodierer 15 und einem Datensignaldecodierer 21 zugeführt.

Zur Verdeutlichung der Erfindung wird das oben begonnene Zahlenbeispiel weitergeführt. Weicht die Frequenz des unstabilisierten Taktsignales 12 um 3 % nach oben ab, so beträgt die erzeugte Frequenz 49,44 MHz. Während einer Synchronisationssignalperiode von 1 ms werden also 49.440 Taktsignale erzeugt, während die Solltaktpulsanzahl 48.000 ensprechend 48 MHz beträgt. Es müssen demnach 1.440 Impulse unterdrückt werden, vorteilhafterweise in gleichen Abständen. In diesem Fall würde also ungefähr jeder 34ste Puls weggefiltert werden.

Der Datensignaldecodierer 21 decodiert nun unter Zuhilfenahme der Solltaktfreuquenz von 12 MHz das über die Leitungen D+ und D- anliegenden Eingangssignal 3 und gibt es als decodiertes Ausgangssignal 22 zur Weiterverarbeitung aus.

Das Senden von Daten erfolgt natürlich ebenso unter Verwendung der gleichen stabilisierten Taktfrequenz von 12 MHz.

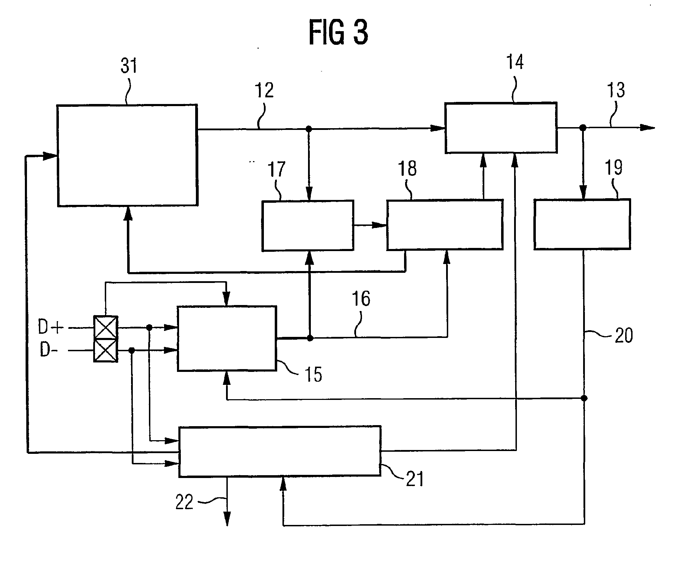

In dem erweiterten Ausführungsbeispiel von Figur 3 ist ein interner Taktgenerator 31 nachjustierbar ausgestaltet. Unter Verwendung des Synchronisationssignals 16 und dem im Pulszahlspeicher 18 abgelegten Wert beziehungsweise unter Verwendung eines Ausgangssignales des Datensignaldecodierers 21 wird die von dem internen Taktgenerator 31 erzeugte Frequenz nachgestimmt. Dadurch sind die Unterschiede zwischen dem unstabilisierten Taktsignal 12 und dem stabilisierten Taktsignal 13 von vorneherein wesentlich geringer.

Eine weitere Möglichkeit der Verbesserung des Regelverhaltens besteht darin, daß nicht nur die Anzahl der Pulse einer vorangegangenen Synchronisationssignalperiode ausgewertet wird, sondern zwischen mehreren vorausgehenden Perioden ein Mittelwert gebildet wird. Dadurch sind die auftretenden Extremwerte der Pulsanzahl wesentlich geringer.

Selbstverständlich ist die Erfindung nicht auf den USB Full-Speed-Modus beschränkt, sondern auch im Low-Speed-Modus anwendbar. Allerdings beträgt hier die geforderte Genauigkeit 1,5 %, was wesentlich einfacher zu erreichen ist.

Weiterhin ist Erfindung auf andere Applikationen anwendbar, sofern ein hinreichend genaues Synchronisationssignal zu Verfügung steht.

### Bezugszeichenliste

- 1: USB-Host
- 2: USB-Gerät
- 3: Eingangssignal
- 11; 31: interner Taktgenerator
- 12: unstabilisiertes Taktsignal
- 13: stabilisiertes Taktsignal
- 14: Pulsfilter
- 15: Synchronisationsdecoder
- 16: Synchronisationssignal
- 17: Pulszähler
- 18: Pulszahlspeicher
- 19: Frequenzteiler
- 20: Arbeitstaktsignal
- 21: Datensignaldecoder
- 22: Ausgangssignal

## Patentansprüche

1. Taktgeneratoreinheit mit
- einem internen Taktgenerator (11; 31), der als Taktsignal (12) Taktpulse mit einer internen Taktfrequenz erzeugt, die höher oder gleich ist im Vergleich zur Solltaktfrequenz eines auszugebenden stabilisierten Taktsignales (13),
- einem Pulszähler (17), der mit dem internen Taktgenerator (11; 31) verbunden ist und der durch ein zugeführtes Synchronisationssignal (16), das aus aufeinander folgenden Synchronisationspulsen besteht, auf einen Startwert setzbar ist, wobei der Pulszähler die von dem internen Taktgenerator (11; 31) erzeugten Taktpulse zählt,
- einem Pulszahlspeicher (18), in dem als Istwert die Anzahl der erzeugten Taktpulse zwischen vorhergehenden Pulsen des Synchronisationssignals (16) speicherbar ist, und
- einem Pulsfilter (14), der aus der in dem Pulszahlspeicher (18) gespeicherten Anzahl und einer festgelegten Sollanzahl von Taktpulsen die Anzahl von aus dem erzeugten Taktsignal (12) auszufilternden Pulsen ermittelt und das erzeugte Taktsignal (12) derart filtert, daß eine der Sollanzahl entsprechende Anzahl von Taktpulsen als stabilisiertes Taktsignal (13) abgreifbar ist.

2. Taktgeneratoreinheit nach Anspruch 1,
**dadurch gekennzeichnet, daß**
der Pulszahlspeicher (18) die Anzahl der erzeugten Taktpulse zwischen zwei vorhergehenden Pulsen des Synchronisationssignales (16) enthält.

3. Taktgeneratoreinheit nach Anspruch 1,
**dadurch gekennzeichnet, daß**
der Pulszahlspeicher (18) eine mittlere Anzahl von erzeugten Taktpulsen zwischen mehreren vorhergehenden Pulsen des Synchronisationssignales (16) enthält.

4. Taktgeneratoreinheit nach Anspruch 1,
**dadurch gekennzeichnet, daß**
das Synchronisationssignal (16) durch einen Synchronisationsdecoder (15) aus einem Eingangssignal (3) ermittelt wird und das stabilisierte Taktsignal (13) mit dem Synchronisationsdecoder (15) verbunden ist.

5. Taktgeneratoreinheit nach Anspruch 1,
**dadurch gekennzeichnet, daß**
das Synchronisationssignal (16) das gemäß den USB-Spezifikationen vorgesehene Synchronisationssignal ist.

6. Taktgeneratoreinheit nach Anspruch 1,
**dadurch gekennzeichnet, daß**
die stabilisierte Taktfrequenz (13) am Ausgang des Pulsfilters (14) in einem gradzahligen Verhältnis höher ist als die benötigte Sollfrequenz eines Arbeitstaktsignales (20), wobei ein Frequenzteiler (19) vorgesehen ist, der das Arbeitstaktsignal (20) durch Teilung aus dem stabilisierten Taktsignal (13) am Ausgang des Pulsfilters (14) erzeugt.

## Claims

1. A clock generator unit having
- an internal clock generator (11; 31) which generates clock pulses (12) at an internal clock frequency which is higher than or equal to the nominal clock frequency of an outputted stabilized clock signal,
- a pulse counter (17) which is connected to the internal clock generator (11; 31) and can be set to a start value by a fed synchronization signal (16), wherein the synchronization signal (16) consists of sequent synchronization pulses, and wherein the pulse counter (17) counts the clock pulses which are generated by the intern pulse generator (11, 31),
- a pulse number memory (18) which can store, as an actual value, the number of clock pulses generated between preceding pulses of the synchronization signal (16), and
- a pulse filter (14) which uses the number stored in the pulse number memory (18) and a stipulated nominal number of clock pulses to ascertain the number of pulses which need to be filtered out of the generated clock signal (12), and which filters the generated clock signal (12) such that a number of clock pulses which corresponds to the nominal number can be tapped off as a stabilized clock signal (13).

2. The clock generator unit as claimed in claim 1, **characterized in that** the pulse number memory (18) contains the number of clock pulses generated between two preceding pulses of the synchronization signal (16).

3. The clock generator unit as claimed in claim 1, **characterized in that** the pulse number memory (18) contains an average number of clock pulses generated between a plurality of preceding pulses of the synchronization signal (16).

4. The clock generator unit as claimed in claim 1, **characterized in that** the synchronization signal (16) is ascertained from an input signal (3) by a synchronization decoder (15), and the stabilized clock signal (13) is connected to the synchronization decoder (15).

5. The clock generator unit as claimed in claim 1, **characterized in that** the synchronization signal (16) is the synchronization signal provided in accordance with the USB specifications.

6. The clock generator unit as claimed in claim 1, **characterized in that** the stabilized clock frequency (13) at the output of the pulse filter (14) is higher, in an even-numbered ratio, than the required nominal frequency of an operating clock signal (20), with a frequency divider (19) being provided which generates the operating clock signal (20) by division from the stabilized clock signal (13) at the output of the pulse filter (14).

## Revendications

1. Unité de générateur d'horloge comprenant
- un générateur (11 ; 31) d'horloge interne, qui produit, comme signal (12) d'horloge, des impulsions d'horloge ayant une fréquence d'horloge interne, qui est supérieure ou égale à la fréquence d'horloge de consigne d'un signal (13) d'horloge stabilisé à émettre,
- un compteur (17) d'impulsions, qui est relié au générateur (11 ; 31) d'horloge interne et qui peut être mis à une valeur de départ par un signal (16) de synchronisation qui est envoyé et qui est constitué d'impulsions de synchronisation qui se succèdent, le compteur d'impulsions comptant les impulsions d'horloge produites par le générateur (11 ; 31) d'horloge interne,
- une mémoire (18) de nombre d'impulsions, dans laquelle peut être mémorisé, comme valeur réelle, le nombre des impulsions d'horloge produites entre des impulsions précédentes du signal (16) de synchronisation, et
- un filtre (14) d'impulsions qui détermine, à partir du nombre mémorisé dans la mémoire (18) de nombre d'impulsions et d'un nombre de consignes fixé d'impulsions d'horloge, le nombre d'impulsions à filtrer du signal (12) d'horloge produit et filtre le signal (12) d'horloge produit de façon à ce qu'un nombre d'impulsions d'horloge, correspondant au nombre de consigne, puisse être prélevé en tant que signal (13) d'horloge stabilisé.

2. Unité de générateur d'horloge suivant la revendication 1,
**caractérisée en ce que**
la mémoire (18) de nombre d'impulsions contient le nombre des impulsions d'horloge produites entre deux impulsions précédentes du signal (16) de synchronisation.

3. Unité de générateur d'horloge suivant la revendication 1,
**caractérisée en ce que**
la mémoire (18) de nombre d'impulsions contient un nombre moyen d'impulsions d'horloge produites entre plusieurs impulsions précédentes du signal (16) de synchronisation.

4. Unité de générateur d'horloge suivant la revendication 1,
**caractérisée en ce que**
le signal (16) de synchronisation est déterminé à partir d'un signal (3) d'entrée par un décodeur (15) de synchronisation et le signal (13) d'horloge stabilisé est relié au décodeur (15) de synchronisation.

5. Unité de générateur d'horloge suivant la revendication 1,
**caractérisée en ce que**
le signal (16) de synchronisation est le signal de synchronisation prévu suivant les spécifications USB.

6. Unité de générateur d'horloge suivant la revendication 1,
**caractérisée en ce que**
la fréquence (13) d'horloge stabilisée à la sortie du filtre (14) d'impulsions est plus grande, dans un rapport en nombre entier, que la fréquence d'horloge de consigne nécessaire d'un signal (20) d'horloge de travail, dans laquelle il est prévu un diviseur (19) de fréquence, qui produit à la sortie du filtre (14) d'impulsions le signal (20) d'horloge de travail par division à partir du signal (13) d'horloge stabilisée.
